# DEMANDE DE BREVET EUROPEEN

(11) **EP 1 463 102 A2**
(43) Date de publication de la demande: **29.09.2004**
(21) Numéro de dépôt: 04290693.3
(22) Date de dépôt: 15.03.2004
(51) Int. Cl.: H01L 21/336, H01L 21/28, H01L 29/49

(54) **Procédé de fabrication d'un transistor à grille métallique, et transistor correspondant**

(30) Priorité: 25.03.2003 FR 0303647
(71) Demandeur: STMicroelectronics S.A., 92120 Montrouge (FR); COMMISSARIAT A L'ENERGIE ATOMIQUE, 75015 Paris (FR)
(72) Inventeur: Carrière, Nicolas, 38000 Grenoble (FR); Skotnicki, Thomas, 38920 Crolles (FR); Tavel, Brice, 38100 Grenoble (FR)
(74) Mandataire: Zapalowicz, Francis

(57) **Abrégé**

La phase de siliciuration du transistor comporte la formation à partir d'un premier métal (8) d'un premier siliciure de métal (80) sur les régions de drain et de source tandis que la région de grille (30) est protégée par une couche de masque dur (40), le retrait du masque dur, la formation à partir d'un deuxième métal (9) d'un deuxième siliciure de métal (90) sur la région de grille tandis que le premier siliciure de métal (80) est protégé par le deuxième métal (9), et le retrait du deuxième métal (9).

## Description

L'invention concerne les circuits intégrés et plus particulièrement la fabrication des transistors à grilles métalliques.

L'utilisation de grilles métalliques permet d'améliorer les propriétés des transistors à effet de champ à grilles isolées (transistors MOS), notamment en diminuant la résistance de grille, en évitant les problèmes d'appauvrissement de grilles ainsi que de diffusion du bore, et en augmentant la tension de seuil du transistor.

Tous les procédés actuels de réalisation de grilles métalliques sont basés sur des procédés du type Damascène, selon une dénomination bien connue de l'homme du métier. Dans de tels procédés, une étape de polissage mécano-chimique permet de protéger les zones actives du transistor (drain et source) lors de la métallisation de la grille.

Il est en effet particulièrement avantageux, en particulier dans des applications radiofréquences, de pouvoir découpler la siliciuration des zones actives de la siliciuration de la grille de façon à déposer un siliciure de métal d'épaisseur différente sur la grille et sur les régions de source et de drain.

Cependant, l'étape de polissage mécano-chimique est une opération délicate qui introduit de fortes variations sur la hauteur finale des grilles, et qui présente un faible rendement.

L'invention vise à remédier à ces inconvénients.

L'invention vise tout particulièrement la réalisation de grilles métalliques par siliciuration totale de la région de grille, tout en évitant de siliciurer trop profondément les régions de source et de drain.

L'invention propose un procédé de réalisation d'une grille métallique d'un transistor comprenant une siliciuration totale de la région de grille.

Cette siliciuration totale de la région de grille est par exemple découplée de la siliciuration des régions de source et de drain.

Selon un mode de mise en oeuvre, la phase de siliciuration du procédé de fabrication du transistor à grille métallique, comporte
- la formation à partir d'un premier métal, d'un premier siliciure de métal sur les régions de drain et de source, tandis que la région de grille est protégée par une couche de masque dur,
- le retrait du masque dur,
- la formation à partir d'un deuxième métal, d'un deuxième siliciure de métal dans la totalité de la région de grille de façon à siliciurer totalement la région de grille, tandis que le premier siliciure de métal est protégé par le deuxième métal ; et
- le retrait du deuxième métal.

Ainsi, l'invention s'affranchit de l'utilisation d'une étape de polissage mécano-chimique en rendant impossible la reprise de siliciuration sur les zones actives (car le deuxième métal ne réagit pas avec le premier siliciure de métal) et en utilisant une couche de masque dur, ce qui permet également de découpler la siliciuration des zones actives de la siliciuration de la grille.

Dans certaines applications, il est particulièrement avantageux de rendre le moins résistif possible le ou les siliciures de métal formés. Aussi, est-il avantageux que la phase de siliciuration comporte un recuit final du premier siliciure de métal et du deuxième siliciure de métal, de façon à former respectivement un premier siliciure final de métal et un deuxième siliciure final de métal.

Le premier métal et le deuxième métal peuvent être identiques.

En variante, le premier métal et le deuxième métal peuvent être différents.

Ainsi, le premier métal et le deuxième métal peuvent être choisis par exemple dans le groupe formé par le titane (Ti), le platine (Pt), le nickel (Ni), le cobalt (Co).

Quant au masque dur, il peut être formé par exemple de nitrure de titane ou bien encore d'un alliage de silicium et de germanium (SiₓGe₁₋ₓ).

Selon un mode de mise en oeuvre de l'invention, la formation du premier siliciure de métal comporte par exemple un dépôt du premier métal sur les régions de drain et de source, et un premier recuit initial.

Par ailleurs, la formation du deuxième siliciure de métal comporte par exemple un dépôt du deuxième métal sur la région de grille et sur le premier siliciure de métal, et un deuxième recuit initial.

Lorsque les régions de source, de drain et de grille comporte du silicium, on peut choisir du cobalt comme premier métal et comme deuxième métal.

Dans ce cas, le premier recuit initial et le deuxième recuit initial sont effectués par exemple à une température inférieure à 600°C environ, de façon à former du CoSi en tant que premier siliciure de métal et deuxième siliciure de métal.

Par ailleurs, le recuit final peut être effectué à une température supérieure à 650°C environ, de façon à former du CoSi₂ (moins résistif que le CoSi) en tant que premier siliciure final de métal et deuxième siliciure final de métal.

L'invention a également pour objet un circuit intégré comportant au moins un transistor obtenu par le procédé tel que défini ci-avant.

D'autres avantages et caractéristiques de l'invention apparaîtront à l'examen de la description détaillée d'un mode de mise en oeuvre du procédé selon l'invention, nullement limitatif, et illustré sur les dessins annexés, sur lesquels :

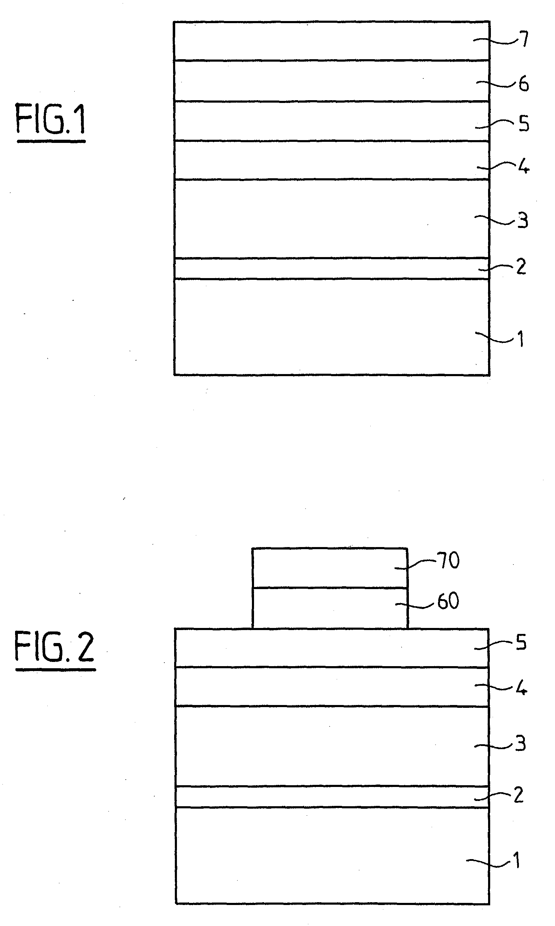

- les figures 1 à 14 illustrent schématiquement les principales étapes d'un mode de mise en oeuvre du procédé selon l'invention, permettant d'aboutir à un transistor selon l'invention.

Sur la figure 1, la référence 1 désigne un substrat semiconducteur, par exemple en silicium, ce substrat pouvant être éventuellement un caisson incorporé au sein d'une plaquette de silicium.

Sur ce substrat 1, on forme, de façon classique et connue en soi, par exemple par oxydation thermique, une couche d'oxyde 2 qui va être destinée à former l'oxyde de grille du futur transistor.

Puis, on forme, également de façon classique et connue en soi, une couche de polysilicium 3 sur la couche d'oxyde 2, par exemple par un dépôt.

A titre indicatif, la couche de polysilicium qui va, comme on va le voir dans l'exemple ci-après, être destinée à être siliciurée pour former la grille métallique du transistor, a une épaisseur de 1000 à 1500 Å.

On dépose ensuite sur la couche de polysilicium 3, une couche de masque dur 4, par exemple formée de nitrure de titane TiN, et ayant par exemple une épaisseur de l'ordre de 100 Å.

On forme ensuite sur la couche de masque dur TiN, une couche de dioxyde de silicium qui, comme on le verra ci-après, va servir également de masque dur lors de la gravure de la grille.

Sur cette couche de dioxyde de silicium 5, on forme une autre couche de polysilicium 6, qui servira de masque dur lors de la gravure de la couche 5.

Enfin, on dépose, de façon classique et connue en soi, une couche de résine 7 sur la couche de polysilicium 6.

On définit ensuite, de façon classique et connue en soi, la géométrie de la grille par une étape de photolithographie. Puis, après avoir insolé et développé la résine, on procède à une gravure classique de celle-ci, le bloc de résine 70 subsistant après gravure correspondant à la géométrie de la future grille du transistor (figure 2).

On utilise également le masque de résine 70 pour graver la couche de polysilicium 6 et laisser par conséquent subsister un reliquat 60 de polysilicium.

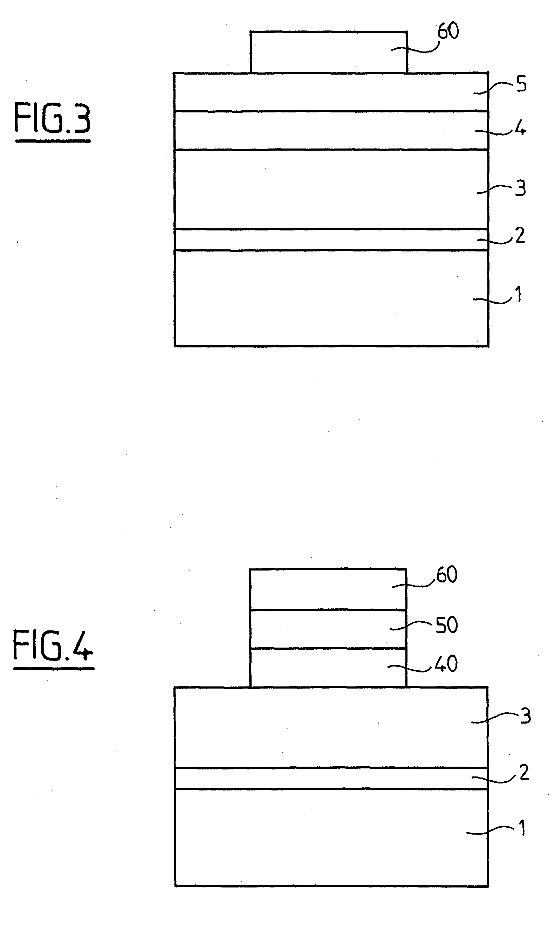

Après retrait de la résine, on obtient la structure illustrée sur la figure 3.

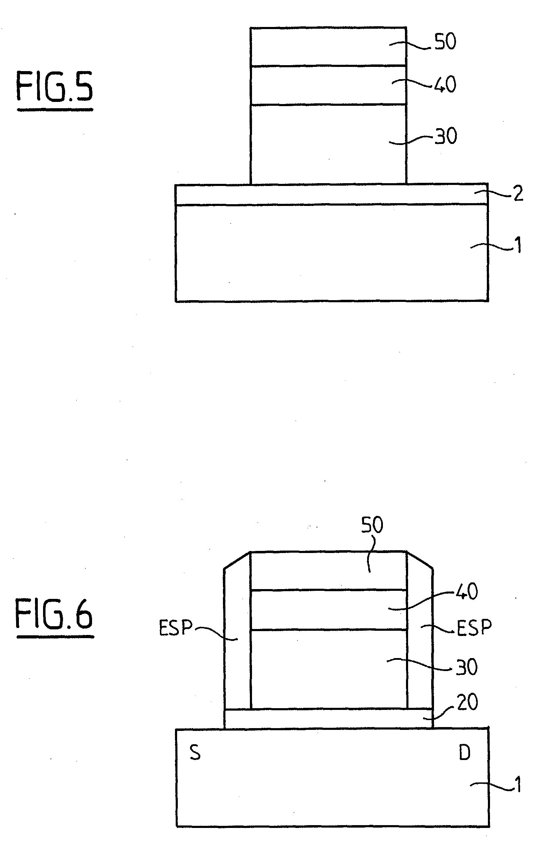

Le reliquat 60 de polysilicium va alors servir de masque dur lors de la gravure de la couche d'oxyde 5 (figure 4).

On prolonge alors l'opération de gravure par une gravure anisotrope classique de la couche de masque dur 4 en TiN et l'on obtient alors la structure de la figure 4.

Après retrait du reliquat de polysilicium 60 (figure 5), le reliquat 50 d'oxyde va servir de masque dur pour graver le reste de la grille, c'est-à-dire la couche de polysilicium 3.

Après cette opération de gravure, on obtient la structure illustrée sur la figure 5, qui comporte le polysilicium de grille 30 surmonté de la couche de masque dur 40 en TiN, elle-même surmontée du reliquat 50 d'oxyde.

On procède ensuite, par un procédé classique et connu en soi, à la suite des étapes de fabrication du transistor MOS, c'est-à-dire en particulier à la formation de régions latérales isolantes, ou espaceurs ESP, sur les flancs de la grille, ainsi qu'à la gravure de la couche d'oxyde 2, de façon à former l'oxyde de grille 20, et la formation par implantation des régions de source et de drain S et D.

Il convient de noter ici que, au cours de ces opérations, la couche de masque dur 40 est protégée des opérations habituelles de nettoyage par la couche d'oxyde 50 qui l'encapsule.

On va alors procéder à la phase de siliciuration des régions de source, de drain et de grille.

Dans l'exemple décrit ici, la siliciuration, c'est-à-dire la formation d'un siliciure de métal, est obtenue à partir de cobalt.

Puisque le cobalt est incapable de réduire l'oxyde de silicium, on procède tout d'abord à une étape de désoxydation de façon à nettoyer les zones actives, c'est-à-dire les zones de source et de drain. Cette désoxydation s'effectue par exemple en utilisant de l'acide fluorhydrique.

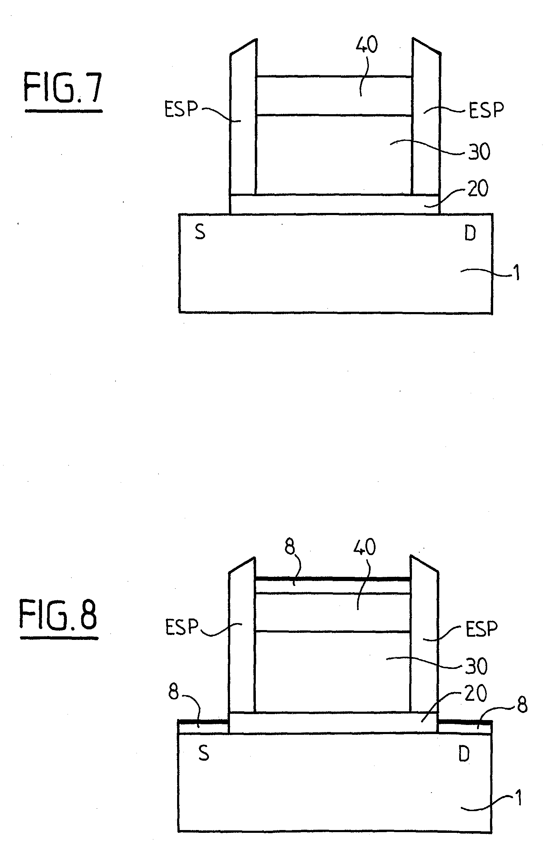

La désoxydation élimine également le reliquat 50 de dioxyde de silicium. Par conséquent, à ce stade, la grille 30 n'est plus protégée que par la couche de masque dur 40 en TiN (figure 7).

On dépose ensuite (figure 8), par exemple par un dépôt plasma en phase vapeur (dépôt PVD), une couche de cobalt 8 sur les régions de source, de drain, et également sur la couche de masque dur 40.

Bien entendu, l'épaisseur de la couche 8 est déterminée en fonction de l'épaisseur de siliciure de métal que l'on souhaite finalement obtenir sur les régions de source et de drain, sachant que lorsque du cobalt est utilisé, 1 Å de cobalt donne 3,4 Å de siliciure.

Puis, on procède à un premier recuit initial, typiquement à une température inférieure à 600°C, par exemple à une température de l'ordre de 530°C.

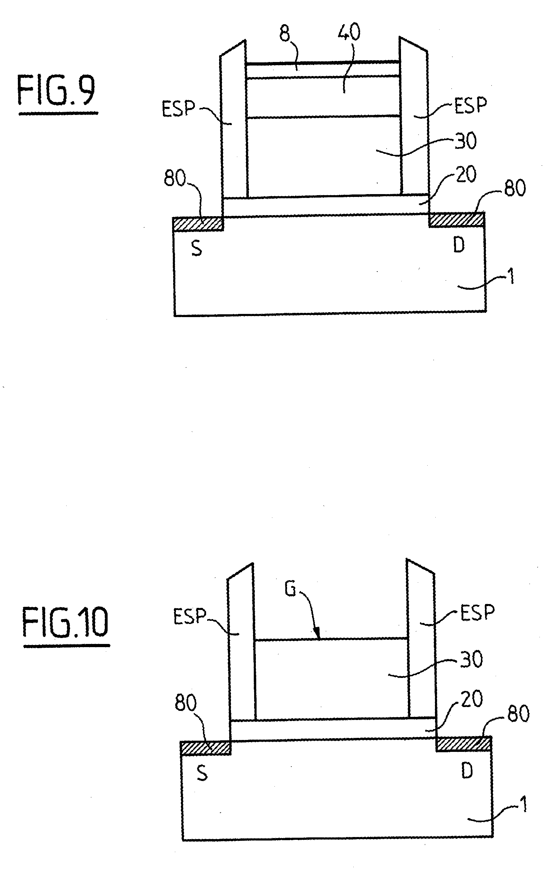

Le cobalt 8 réagit alors avec le silicium des régions de source et de drain, pour former du CoSi 80 (figure 9).

Par contre, le cobalt 8, qui a été déposé sur la couche de masque dur 40, ne réagit pas avec le polysilicium 30 de la grille, puisque celle-ci est protégée par la couche de masque dur 40.

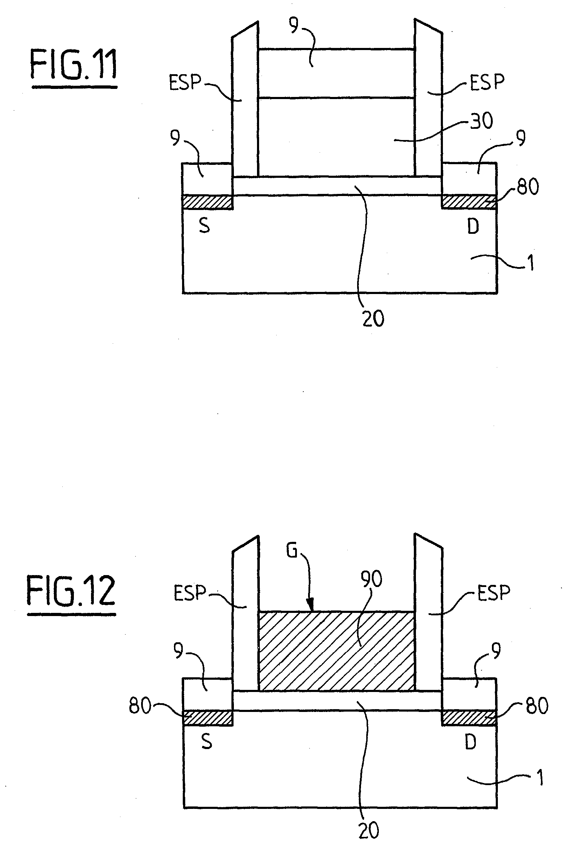

Le cobalt n'ayant pas réagi (c'est-à-dire le cobalt qui se situait sur la couche de masque dur 40, et éventuellement un résidu de cobalt n'ayant pas réagi avec le silicium des régions de source et de drain) est ensuite retiré (figure 10) par une opération de retrait sélectif. Cette opération de retrait sélectif s'effectue par exemple par gravure humide. Une telle gravure humide est classique et connue en soi, et elle utilise par exemple une chimie NH₄OH ; H₂O₂ ; H₂O, ou bien une chimie HCl, H₂O₂, H₂O.

Cette opération de gravure humide grave également la couche de masque dur 40 en nitrure de titane (figure 10).

Une couche épaisse de cobalt 9 est alors déposée sur la structure de la figure 10, l'épaisseur de cette couche de cobalt 9 étant déterminée de façon à siliciurer ici l'ensemble de la grille 30.

On procède ensuite à un deuxième recuit initial, analogue au premier recuit initial, de façon à faire réagir le cobalt 9 avec le polysilicium 30 de la grille et former du CoSi 90 (figure 12).

Il convient de noter ici que le cobalt présente la particularité de ne pas réagir avec le CoSi 80 des régions de source et de drain.

Par conséquent, le cobalt 9 a protégé le siliciure de métal 80 formé sur les régions de source et de drain lors de l'opération de siliciuration de la grille. Il a donc été possible selon l'invention de découpler la siliciuration des régions de source et de drain, et la siliciuration de la région de grille, de façon à pouvoir siliciurer les régions de source et de drain sur une faible épaisseur, par exemple environ 300 Å, tout en siliciurant totalement la grille, soit sur environ 1000 à 1500 Å.

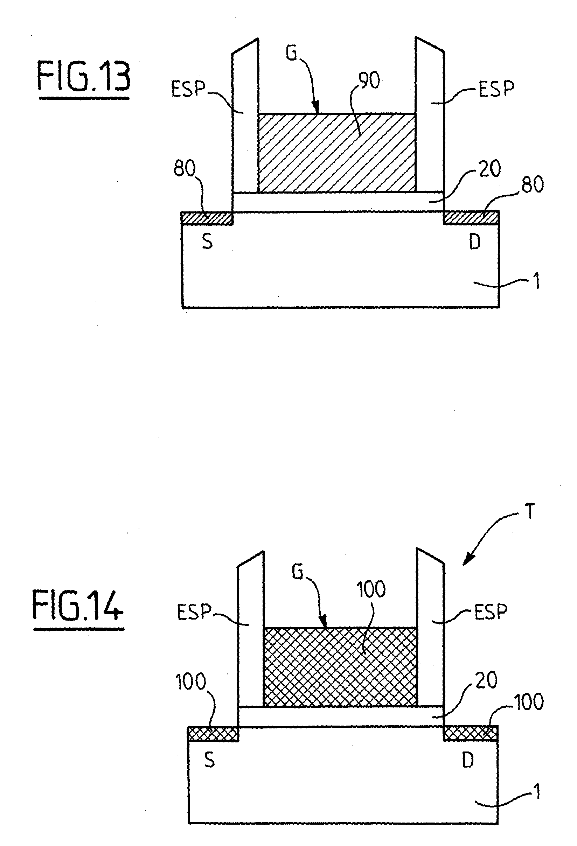

Après retrait du cobalt 9 des régions de source et de drain, on obtient donc la structure illustrée sur la figure 13.

Comme le CoSi est un siliciure de métal très résistif, il est alors particulièrement avantageux, dans certaines applications, de transformer ce CoSi en CoSi₂ beaucoup moins résistif.

Cette opération de transformation est effectuée en procédant à un recuit final, typiquement à une température supérieure à 650°C, par exemple aux alentours de 830°C.

On obtient alors le transistor T illustré sur la figure 14, dont les régions de source et de drain ainsi que la région de grille, sont siliciurées par du CoSi₂ 100.

Le fait que l'empilement Co/CoSi soit stable, en dessous de 600°C, a rendu impossible toute reprise de siliciuration sur les zones actives de source et de drain, ce qui a, en combinaison avec l'utilisation d'une couche de masque dur en TiN, contribué à découpler la siliciuration des zones actives de source et de drain, de la siliciuration de la grille.

Par contre, puisque l'empilement Co/CoSi₂ n'est pas stable, il convient de ne pas effectuer le recuit final de siliciuration des zones actives de source et de drain avant de déposer le cobalt sur la grille.

L'invention n'est pas limitée au mode de réalisation et de mise en oeuvre qui vient d'être décrit, mais en embrasse toutes les variantes.

Ainsi, il est possible d'envisager deux métaux différents pour siliciurer les régions de source et de drain et la grille, à condition bien entendu que l'empilement métal B/siliciure A soit stable. A cet égard, on pourra utiliser du cobalt pour siliciurer la grille et du nickel pour siliciurer les zones actives de source et de drain.

En outre, le masque dur pourrait être également formé d'un alliage de silicium et de germanium.

Par ailleurs l'invention n'est pas limitée à la siliciuration sélective décrite ci-dessus pour la fabrication d'un transistor, mais propose d'une façon plus générale, un procédé de siliciuration comportant la formation d'un siliciure de métal sur deux zones semiconductrices différentes. Ces deux zones différentes étaient dans l'exemple de la fabrication d'un transistor décrit ci-dessus, les régions de source et de drain d'une part, et la région de grille d'autre part

Selon une caractéristique générale de l'invention, ladite phase de siliciuration comporte alors
- la formation à partir d'un premier métal, d'un premier siliciure de métal sur une première zone, tandis que la deuxième zone est protégée par une couche de masque dur,
- le retrait du masque dur,
- la formation à partir d'un deuxième métal, d'un deuxième siliciure de métal sur la deuxième zone, tandis que le premier siliciure de métal est protégé par le deuxième métal ; et
- le retrait du deuxième métal.

## Revendications

1. Procédé de réalisation d'une grille métallique d'un transistor comprenant une siliciuration totale de la région de grille.

2. Procédé selon la revendication 1, **caractérisé par le fait que** la phase de siliciuration comporte
la formation à partir d'un premier métal (8) d'un premier siliciure de métal (80) sur les régions de drain et de source tandis que la région de grille (30) est protégée par une couche de masque dur (40),
le retrait du masque dur,
la formation à partir d'un deuxième métal (9) d'un deuxième siliciure de métal (90) dans la totalité de la région de grille de façon à siliciurer totalement la région de grille, tandis que le premier siliciure de métal (80) est protégé par le deuxième métal (9), et
le retrait du deuxième métal (9).

3. Procédé selon la revendication 2, **caractérisé par le fait que** la phase de siliciuration comporte un recuit final du premier siliciure de métal et du deuxième siliciure de métal de façon à former respectivement un premier siliciure final de métal (100) et un deuxième siliciure final de métal (100).

4. Procédé selon la revendication 2 ou 3, **caractérisé par le fait que** le premier métal (8) et le deuxième métal (9) sont identiques.

5. Procédé selon la revendication 2 ou 3, **caractérisé par le fait que** le premier métal (8) et le deuxième métal (9) sont différents.

6. Procédé selon l'une des revendications 2 à 5, **caractérisé par le fait que** le premier métal et le deuxième métal sont choisis dans le groupe formé par le titane (Ti), le platine (Pt), le nickel (Ni), le cobalt (Co).

7. Procédé selon l'une des revendications 2 à 6, **caractérisé par le fait que** le masque dur (40) est formé de nitrure de titane (TiN) ou d'un alliage de silicium et de germanium (SiₓGe₁₋ₓ).

8. Procédé selon l'une des revendications 2 à 7, **caractérisé par le fait que** la formation du premier siliciure de métal comporte un dépôt du premier métal sur les régions de drain et de source, et un premier recuit initial.

9. Procédé selon l'une des revendications 2 à 8 **caractérisé par le fait que** la formation du deuxième siliciure de métal comporte un dépôt du deuxième métal sur la région de grille et sur le premier siliciure de métal, et un deuxième recuit initial.

10. Procédé selon l'une des revendications 2 à 9, **caractérisé par le fait que** les régions de source, de drain et de grille comportent du silicium et **par le fait que** le premier métal et le deuxième métal sont du cobalt.

11. Procédé selon les revendications 8, 9 et 10, **caractérisé par le fait que** le premier recuit initial et le deuxième recuit initial sont effectués à une température inférieure à 600°C environ de façon à former du CoSi en tant que premier siliciure de métal (80) et deuxième siliciure de métal (90).

12. Procédé selon les revendications 3 et 11, **caractérisé par le fait que** le recuit final est effectué à une température supérieure à 650°C environ, de façon à former du CoSi₂ en tant que premier siliciure final de métal (100) et deuxième siliciure final de métal (100).

13. Procédé selon l'une des revendications précédentes, **caractérisé par le fait que** la siliciuration totale de la région de grille est découplée de la siliciuration des régions de source et de drain.

14. Circuit intégré comportant au moins un transistor obtenu par le procédé selon l'une des revendications 1 à 13.
